# EUROPEAN PATENT APPLICATION

(11) **EP 4 529 378 A1**
(43) Date of publication of application: **26.03.2025**
(21) Application number: 24202191.3
(22) Date of filing: 24.09.2024
(51) Int. Cl.: H05K 7/20, G06F 1/20, H01L 23/427

(54) **METHODS OF COOLING A VERTICAL LINE CARD**

(30) Priority: 25.09.2023 US 202318372346
(71) Applicant: Google LLC, Mountain View, CA 94043 (US)
(72) Inventor: Liu, Tanya, Mountain View, 94043 (US); Iyengar, Madhusudan K., Mountain View, 94043 (US); Lam, Cedric Fung, Mountain View, 94043 (US)
(74) Representative: Betten & Resch

(57) **Abstract**

A system for cooling a vertical line card includes a printed circuit board; an application specific integrated circuit (ASIC) having a front surface, a back surface, and an edge surface connecting the front and back surfaces, the ASIC mountable on the printed circuit board; a vapor chamber mountable on the ASIC, the vapor chamber including a first portion mountable on the front surface of the ASIC and extending away from the front surface and a second portion in fluid communication with the first portion extending away from the first portion at an angle relative to the first portion.

## Description

### BACKGROUND

Vertical line cards ("VLC") are improvements in conventional data center architectures. Conventional data centers implementing network switches use Horizontal Line Card ("HLC") architectures that attach Application Specific Integrated Circuit ("ASIC") chips to a horizontally oriented Printed Circuit Board (PCB). HLCs further include various other ports, such as optics ports, that are typically positioned toward the front of the PCB on which the ASIC is mounted.

In order to prevent degradation of the ASIC and surrounding ports due to overheating, conventional data centers implement front-to-back cooling airflow that passes over the optics ports, PCB, and ASIC to absorb the heat generated from such components. This cooling airflow also passes through heat sinks with planar bases that are horizontally oriented parallel to the direction of airflow. HLC architecture is not without drawbacks. HLC architecture has higher high-speed signal trace lengths and requires more PCBs than other data center architectures, which in turn increases the overall footprint of the HLC architecture.

VLC architecture cannot be cooled using the same cooling methods as conventional HLC architectures. Planar heatsinks may be constrained by the VLC chassis height and by additional optics modules adjacent to the VLC chassis. VLCs are sometimes cooled by routing a heat pipe having a 90° bend from an ASIC to a remote heatsink oriented parallel to the direction of airflow. The heat pipes are soldered directly to a solid heatsink base or to a vapor chamber. Although heat pipes generally have high thermal conductivities, an inevitable temperature drop occurs along the length of the heat pipe as heat is transferred across the length of the pipe. In high power ASIC applications, this temperature drop is exacerbated, and more heat will be released from the heat pipe closer to the ASIC. Additionally, the soldering points between the heat pipe and heatsink base create contact resistance points that increase the thermal resistance of the system.

### BRIEF SUMMARY

According to one aspect of the present disclosure, a system for cooling a vertical line card comprises a printed circuit board; an application specific integrated circuit (ASIC) having a front surface, a back surface, and an edge surface connecting the front and back surfaces, the ASIC mountable on the printed circuit board; a vapor chamber mountable on the ASIC, the vapor chamber including a first portion mountable on the front surface of the ASIC and extending substantially parallel away from the front surface and a second portion in fluid communication with the first portion extending away from the first portion at an angle relative to the first portion.

In some examples, the first portion of the vapor chamber is configured to be soldered to the ASIC.

In some examples, the second portion of the vapor chamber extends substantially orthogonal relative to the first portion.

In some examples, the system further comprises a third portion of the vapor chamber extending substantially orthogonal relative to the first portion and parallel relative to the second portion, the vertical line card positionable between the second and third portions.

In some examples, the system further comprises a first heat pipe configured to connect the first portion to the second portion, and a second heat pipe configured to connect the first portion to the third portion.

In some examples, the first portion of the vapor chamber includes an evaporator.

In some examples, the second portion of the vapor chamber includes a condenser.

In some examples, the system further comprises an airflow manifold mountable to a front surface of the first portion of the vapor chamber.

In some examples, the airflow manifold includes a plurality of apertures, each aperture of the plurality of apertures spaced apart from an adjacent aperture.

In some examples, the airflow manifold is in a mounted configuration, each aperture aligns with a component of the printed circuit board.

In some examples, an aperture includes a tapered opening.

In some examples, the system further comprises a plurality of fans, each fan of the plurality stacked on top of an adjacent fan.

In some examples, each fan includes an individual power controller.

According to another aspect of the present disclosure, a system for cooling a vertical line card comprises a printed circuit board; an application specific integrated circuit (ASIC) mountable on a back side of the printed circuit board such that the ASIC and the printed circuit board both extend along substantially vertical planes; a heat sink mountable on the ASIC; a heat pipe extending from the heat sink; and a fin mountable on the heat pipe.

In some examples, the ASIC is mountable to a back surface of the printed circuit board.

In some examples, the heat sink is a vapor chamber.

In some examples, the heat pipe includes a plurality of heat pipes, each heat pipe extending radially outward from the heat sink.

In some examples, the plurality of heat pipes extend radially outward from each of four lateral surfaces of the heat sink.

In some examples, the fin includes a plurality of fins forming a fin block, each fin block mountable on a set of three heat pipes.

In some examples, the fin is circular.

In some examples, the fin extends entirely around the perimeter of the heat sink.

### BRIEF DESCRIPTION OF THE DRAWINGS

FIG. 1 is a perspective view of a data center according to aspects of the disclosure.
FIG. 2 is a side view of a first cooling system according to aspects of the disclosure.
FIG. 3 is a side view of an alternative implementation of the first cooling system of FIG. 2.
FIG. 4 is a side view of another alternative implementation of the first cooling system of FIG. 2.
FIG. 5 is a side view of a second cooling system according to aspects of the disclosure.
FIG. 6 is an enhanced side view of a portion of the second cooling system of FIG. 5.
FIG. 7 is a side view of another example implementation of a jet impingement manifold of FIG. 5.
FIG. 8 is a front view of a jet impingement manifold implementable with the cooling system of FIG. 5.
FIG. 9 is a front view of another jet impingement manifold implementable with the cooling system of FIG. 5.
FIG. 10 is a perspective view of a data center implementing a cooling system with various plenums.
FIG. 11 is a side view of a third cooling system according to aspects of the disclosure.
FIG. 12 is a perspective view of the cooling system of FIG. 11.
FIG. 13 is a back view of the cooling system of FIG. 11.
FIG. 14 is a perspective view of another example implementation of the cooling system of FIG. 11.
FIG. 15 is a front view of the cooling system of FIG. 14.
FIG. 16 is a side view of the cooling system of FIG. 14.
FIG. 17 is a side view of a fourth cooling system according to aspects of the disclosure.
FIG. 18 is a side view of another example implementation of the cooling system of FIG. 17.

### DETAILED DESCRIPTION

Reference will now be made in detail to the various implementations of the present disclosure illustrated in the accompanying drawings. Wherever possible, the same or like reference numbers will be used throughout the drawings to refer to the same or like features within a different series of numbers, e.g., 100-series, 200-series, etc. It should be noted that the drawings are in simplified form and are not drawn to precise scale. Additionally, the term "a," as used in the specification, means "at least one." The terminology includes the words above specifically mentioned, derivatives thereof, and words of similar import. Although at least two variations are described herein, other variations may include aspects described herein combined in any suitable manner having combinations of all or some of the aspects described.

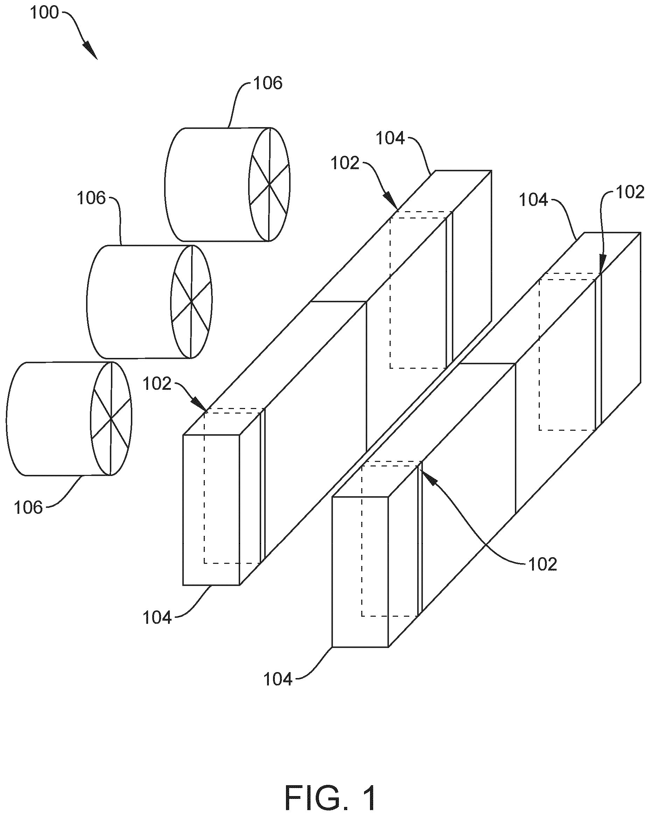

FIG. 1 broadly illustrates a data center 100 including a plurality of vertical line cards (VLC) 102 secured to a plurality of chassis 104. A cooling system implementing fans 106 is positioned adjacent chassis 104 to cool VLC 102 in use. Due to the vertical orientation of the VLC 102 as opposed to a horizontal line card (HLC), conventional cooling heat transfer methods oriented parallel to the ground are unable to properly cool a VLC 102, and thus the improvements in the cooling architecture are described herein.

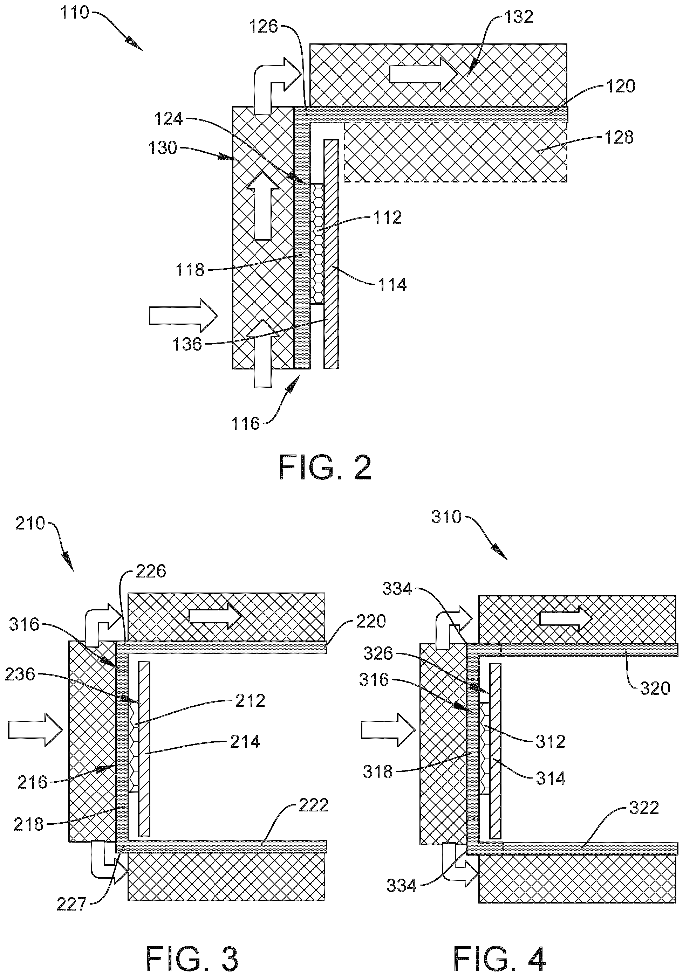

FIG. 2 illustrates a first cooling system 110 for cooling a VLC 102. VLC 102 includes an application specific integrated circuit (ASIC) 112 mountable on a front side 136 of a printed circuit board (PCB) 114. Rather than utilizing heat pipes similar to conventional cooling systems for HLCs, the first cooling system 110 utilizes a vapor chamber 116 that is bent to directly cool the surface of ASIC 112 and direct heat away from ASIC 112. Such a vapor chamber 116 achieves a greater cooling effect on ASIC 112 at least in part because vapor chambers transfer heat in two dimensions, as opposed to a conventional heat pipe which only transfers heat along the length of the pipe.

Continuing with the implementation of FIG. 2, the vapor chamber 116 includes a first portion 118 that is mounted on and extends parallel to a planar front surface 122 of ASIC 112. The vapor chamber 116 may be mounted to ASIC 112 by soldering or by mechanical attachments such as pins or fasteners. The first portion 118 includes an evaporator and condenser to collect the heat generated from ASIC 112, PCB 114, and any heat that has transferred to ASIC 112 from PCB 114, and transfer the collected heat to a second portion 120 of the vapor chamber 116. The second portion 120 of the vapor chamber 116 acts as a remote condenser to release the collected heat from the first portion 118 away from the second portion 120 and away from ASIC 112. The second portion 120 extends generally perpendicular to first portion 118 via a 90° bend 126 in vapor chamber 116. Thus, second portion 120 extends over the top of VLC 102 as viewed from the side. In alternative implementations, bend 126 may not be exactly 90°, and may be formed at a different angle, such as 60° or 120° for manufacturing feasibility or to avoid contacting various components of VLC 102.

Vapor chamber 116 includes a wick optimized to vaporize liquid in the evaporator of first portion 118. Due to the capillary forces acting on the wick between the condenser and evaporator portions of the vapor chamber 116, the vapor chamber 116 transfers heat regardless of its orientation, even if the evaporator is positioned above the condenser. Accordingly, various orientations of the first and second portions 118, 120 of vapor chamber 116 may be implemented with VLC 102 without sacrificing cooling performance.

The first cooling system 110 may be optimized for a VLC chassis by modifying the thicknesses and widths of the first and second portions 118, 120. Specifically, the second portion 120 may be thicker than the first portion 118 by increasing its diameter or other cross-sectional shape to increase the surface area and heat transfer potential of second portion 120 relative to first portion 118. Second portion 120 may further include a plurality of fins or other surface-area enhancing features in an area 128 that does not interfere with the components VLC 102 such that the fins extend away from a longitudinal axis of the second portion to increase the heat transfer away from the second portion 120. Such a system may also avoid the vapor pressure drops seen in conventional heat pipe systems in which the pressure drop increases with heat pipe length, which in turn increases the thermal resistance of a conventional heat pipe.

In use, cooling air is blown toward the front surface of first portion 118 and then passes along a first cooling airflow path 130 parallel to first portion 118. After bend 126, the cooling air passes along a second cooling airflow path 132 parallel to second portion 120. The cooling air collects the heat generated from VLC 102 and transfers that heat away from VLC 102.

FIG. 3 illustrates another implementation 210 of the first cooling system 110 utilizing a bent vapor chamber 216. Rather than the vapor chamber having a single bend like vapor chamber 116 of first cooling system 110, vapor chamber 216 has a first bend 226 and second bend 227. While the example of Fig. 3 illustrates both the first bend 226 and the second bend 227 as being substantially 90° bends, the angle of the first bend 226 and second bend 227 may vary. Moreover, the first bend 226 may have the same angle as the second bend 227 or different angle.

First bend 226 causes a second portion 220 of vapor chamber 216 to extend over a top surface of VLC 202 and second bend 227 causes a third portion 222 to extend under a bottom surface of VLC 202. Thus, vapor chamber 216 covers VLC 202 on at least the front, top, and bottom sides of VLC 202, and may allow for a greater transfer of heat away from ASIC 212 and VLC 202. First portion 218 is vertically mounted to the front side 224 of ASIC 212. First portion 218 may include an evaporator and extends longitudinally past the edges of ASIC 212 and PCB 214. A second portion 220 may extend from a first bend 226 located above VLC 202, and a third portion 222 may extend from a second bend 227 located below VLC 202. As such, the vapor chamber 216 forms a U-shape around VLC 202 and provides additional cooling potential by releasing heat away from the top and bottom portions of VLC 202 via heat transfer from ASIC 212 through vapor chamber 216. The second and third portions 220, 222 may include condenser portions to release the collected heat from the evaporator of the first portion 218 away from VLC 202.

FIG. 4 illustrates another implementation 310 of the first cooling system 110 utilizing substantially straight vapor chamber portions and bent heat pipe portions. A U-shaped vapor chamber 316 may be positioned around a VLC 302 on the front, top, and bottom sides of the VLC 302. Vapor chamber 316 includes a first portion 318 mountable to an ASIC 312, a second portion 320 configured to extend over a top portion of VLC 302, and a third portion 322 configured to extend over a bottom portion of VLC 302. Rather than the vapor chamber being bent, each of the first, second, and third portions 318, 320, 322 is substantially straight and is connected by two bent heat pipes 334. The heat pipes 334 may be bent at substantially 90° angles to allow the three vapor chambers to at least partially surround VLC 302. It is appreciated that heat pipes 334 may be bent at angles other than right angles, and that the angle between first and second portions 318, 320 may be different than the angle between first and third portions 318, 322. For example, if a VLC 302 defines an octagonal perimeter, heat pipes 334 may each extend at 120° angles to better account for the periphery of the VLC. Heat pipes 334 are preferably implemented in short lengths to minimize any potential pressure and/or temperature drop that occurs across the length of heat pipes 334. As such, the heat transfer advantages of vapor chambers may be maximized, and the heat transfer disadvantages of heat pipes may be minimized.

Continuing with the example of FIG. 4, each vapor chamber portion includes an evaporator and condenser portion such that each vapor chamber can absorb and reject heat on its own and in conjunction with the adjacent vapor chamber portions. As such, the first vapor chamber 316 may absorb heat from ASIC 312 and transfer it through heat pipes 334 to the adjacent second and third portions 320, 322, which then expel the heat away from VLC 302.

Second and third portions 320, 322 may be designed to extend past VLC 302 on at least the upper and lower sides such that additional fins or other surface area enhancing features may be positioned along the length of second and third portions 320, 322. These additional fins facilitate additional heat transfer and help guide warm air away from VLC 302. The fins may be positioned along second and third portions 320, 322 such that cooling fans used to cool VLC 302 can also be directed at the additional fins to capture heat from the fins and expel the hot air away from VLC 302. The fins may be designed to extend perpendicularly away from second and third portions 320, 322 or at an angle relative to second and third portions 320, 322 depending on the shape of the VLC implemented.

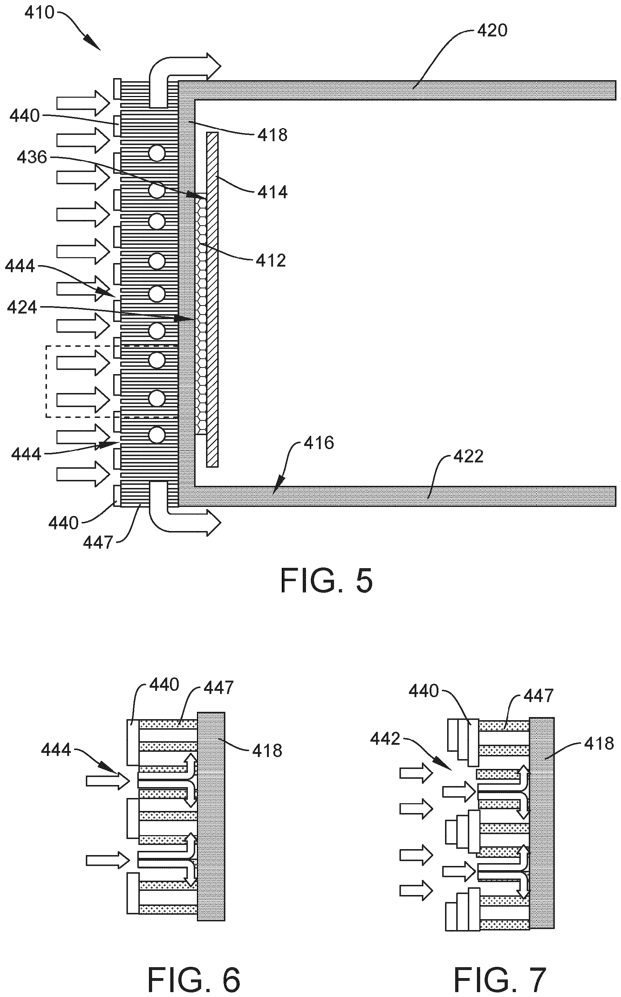

FIG. 5 illustrates a second cooling system 410. In this implementation, second cooling system 410 is similar to first cooling system 110, and therefore like elements are referred to with similar numerals within the 400-series of numbers. Second cooling system 400 includes a VLC 402 including an ASIC 412 mountable on a front side 436 of a PCB 414. Similar to first cooling system 110, second cooling system 410 implements a vapor chamber 416 that acts as a heatsink to distribute heat away from VLC 402. Vapor chamber 416 may be bent around the upper and lower portions of VLC 402 and may include vapor chamber fins (not shown) or other features that increase the overall surface area of the vapor chamber to facilitate additional heat transfer. Alternatively, vapor chamber 416 may be segmented, and each segment may be connected with a bent heat pipe (now shown). In addition to vapor chamber 416, heat transfer may be facilitated by a jet impingement manifold 440 that is vertically mounted on the front surface 438 of vapor chamber 416. Jet impingement manifold 440 directs incoming cooling airflow towards critical components of VLC 402, which resets the boundary layer and causes higher local heat transfer coefficients than the local heat transfer coefficients realized in conventional airflow systems that do not utilize a jet impingement manifold. Jet impingement manifold 440 also maximizes heat transfer directly above the surface of ASIC 412 and reduces remote cooling loads through vapor chamber 416.

Jet impingement manifold 440 may be designed to accommodate a variety of different VLC configurations and architectures. In one example illustrated in FIG. 7, jet impingement manifold 440 includes tapered openings 442 that cause an increase in air velocity closer toward VLC 402. In particular, the tapered openings 442 are positioned within jet impingement manifold 440 such that they align with critical components of VLC 402, such as ASIC 412. Cooling air is then directed to such components at a higher velocity than would otherwise be achieved without jet impingement manifold 440. Tapered openings may be formed by mounting tapered guides 433 to jet impingement manifold 440. Such a mounting may be facilitated by fasteners, adhesives, and the like. Alternatively, tapered guides 433 may be integrally formed with jet impingement manifold 440 through machining, molding, or other manufacturing processes. Tapered guides 433 are formed at angles optimized to increase air velocity while minimizing pressure drop as air passes over tapered guides 433. In certain implementations, specific tapered guides 433 may be formed at a smaller angle, such as a 30° angle, to increase the air velocity towards critical components of the VLC. Other tapered guides 433 may be formed at smaller angles, such as 75° angles, corresponding to components of the VLC that do not produce as much heat.

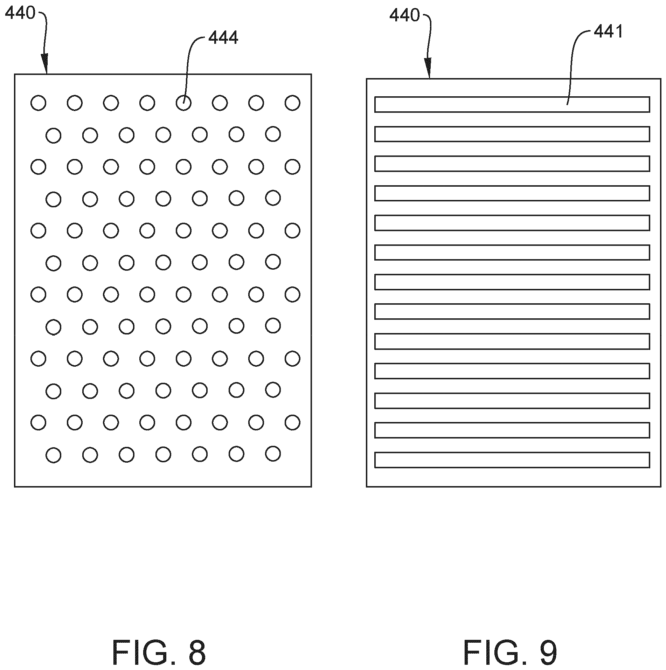

In another example illustrated in FIG. 6 and FIG. 8, the jet impingement manifold 440 may have uniformly spaced holes 444 or openings that are not tapered to provide uniform cooling to a larger surface area of the VLC 402. The holes 444 may be formed by hole guides that are mounted or integrally formed with jet impingement manifold 440. Similar to the example of FIG. 7, holes 444 increase air velocity toward critical components of the VLC than would otherwise be achieved without holes 444.

In another example illustrated in FIG. 9, jet impingement manifold 440 may include horizontal slots 441 that evenly distribute cooling airflow across multiple horizontal planes to the VLC 402 to direct the airflow for horizontal attachment points and edges of critical components, such as the edges of ASIC 412. As such, the jet impingement manifold 440 may increase the velocity of the cooling air and facilitate better cooling than would otherwise be achieved without jet impingement manifold 440 with horizontal slots 441.

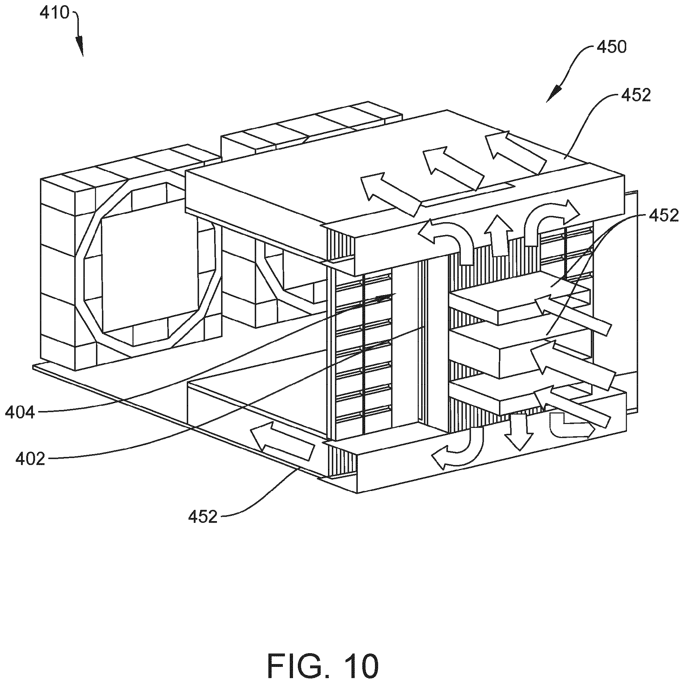

FIG. 10 illustrates a plenum system 450 that may be implemented with second cooling system 410. Although the plenum system 450 is described and illustrated as being implemented with second cooling system 410, it is foreseeable that a plenum system may be implemented with any of the cooling systems described herein. Plenum system 450 may include individual plenums positioned at various locations relative to VLC 402 to assist with moving air around VLC 402, particularly supplying cool air from various fans and cooling systems to VLC 402, expelling hot air away from VLC 402, and resupplying air to the various fans and cooling systems. In one example, plenum 452 includes a plenum box including various ducts, covers, filters, and blowers, in which the blower is configured to push air through a filter and then the air is distributed via the ducts and covers. Plenum 452 is positioned outside of vapor chamber 416 to collect air that has flowed through jet impingement manifold 440. In one example, plenum 452 is positioned above VLC 452 and may direct air to the rear of the VLC chassis 404 such that it can be redirected by a blower within plenum 452 toward the VLC again. In another example, a plenum 452 is positioned below a vapor chamber 416 such that it can collect the expelled heated air from the vapor chamber and direct that heated air away from VLC 402 via the internal blower within plenum 452 positioned beneath VLC 402. Plenum 452 may be manufactured from a polymer or other non-metallic material that can be consistently and easily manufactured through manufacturing methods such as molding or additive manufacturing.

Jet impingement manifold 440 may be mounted on vapor chamber 416 using a mechanical attachment style such as fasteners, flexible bands, and the like. Jet impingement manifold 440 may also be removable such that different shape manifolds can quickly be attached to the VLC chassis if different cooling methods are desired. Jet impingement manifold 440 may be constructed from a variety of materials and does not necessarily need the same heat transfer properties as the underlying heat sink. Thus, plastic materials that can be efficiently and reliably manufactured through methods such as additive manufacturing, injection molding, and the like may be used to create jet impingement manifold 440. Alternatively, jet impingement manifold 440 may be made of metal and formed through various machining, milling, or similar manufacturing methods. Various fins or micropillars 447 may be machined, electroplated, or otherwise formed on jet impingement manifold 440 to aid in the heat transfer properties of the entire system, even if jet impingement manifold 440 is created from a material having a low thermal resistance.

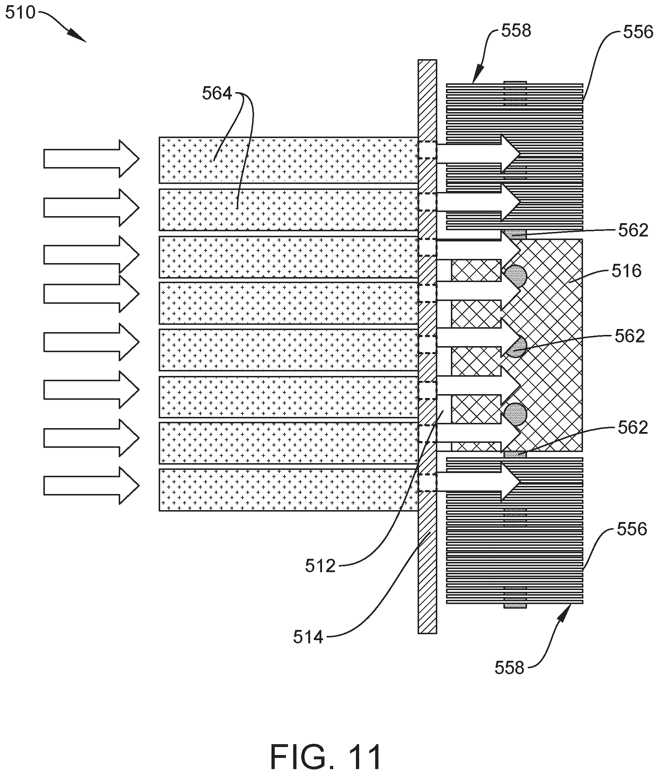

FIG. 11 illustrates a side view of a third cooling system 510. In this implementation, third cooling system 510 is similar to first cooling system 110, and therefore like elements are referred to with similar numerals within the 500-series of numbers. Unlike first and second cooling systems 110, 410, third cooling system 510 includes a VLC 502 including an ASIC 512 vertically mounted on a back side of a PCB 514, which limits the amount of cooling air that can reach ASIC 512. A heatsink in the form of a vapor chamber 516 is directly mounted on the back side of ASIC 512 using similar mounting methods to those already described herein. Vapor chamber 516 may be square, circular, or another shape that is capable of being mounted to ASIC 512. Further, vapor chamber 516 is wicked similar to vapor chambers 116, 416 such that it can transfer heat in any orientation.

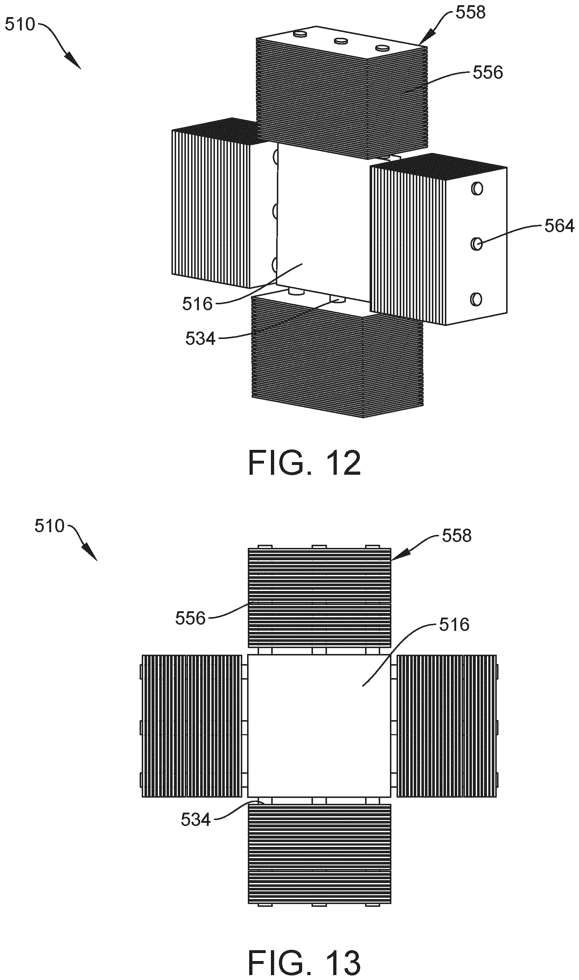

FIG. 12 illustrates a perspective view of the third cooling system 510. A plurality of heat pipes 534 extend radially outward from vapor chamber 516 to form a generally circular or rotary configuration around the periphery of vapor chamber 516. Such an arrangement is also illustrated in FIG. 13, which is a back view of third cooling system 510. The plurality of heat pipes 534 may include four heat pipes, one heat pipe extending from each lateral face of a square-shaped vapor chamber 516. Alternatively, multiple heat pipes may extend from each lateral face of the heat sink, such as three heat pipes extending from each lateral face of the heat sink for a total of twelve heat pipes. In another alternative implementation utilizing a circular vapor chamber 516, heat pipes 534 may be uniformly spaced to extend radially outward away from the center point of the circular vapor chamber 516.

A plurality of fins 556 may be positioned at a distal end of each heat pipe 516 in a block configuration 558, with one fin 556 positioned directly adjacent another fin 556. As such, each fin 556 is a thin piece of a high thermal conductive material, such as copper or aluminum that acts to increase the surface area of the body of the heat pipe and facilitate an increase in heat transfer efficiency. Each fin 556 may have a plurality of apertures 560 formed therethrough, each aperture 560 adapted to receive to a respective heat pipe 534 extending from the vapor chamber 516. The number of fins 556 in each fin block 558 may be adapted for a specific ASIC 512. For example, a higher power ASIC that produces more heat, may require a fin block having a larger number of fins in each fin block, such as 30 fins as compared to 15 fins for a lower power ASIC.

In implementations where the vapor chamber 516 base is square, the corresponding fin blocks 558 extending from each lateral face of the heat sink base extend along a plane that is parallel to the plane defined by the side face of the square heat sink base. As such, each fin block 558 is oriented along a plane 90° from the adjacent fin block to form a generally square shape that extends past the periphery of vapor chamber 516.

In other implementations of the third cooling system 510, the lengths of the heat pipes 534 may vary, and the heat pipes 534 may have bent portions 562 to provide clearance for the fin blocks 558 in relation to the ASIC 512, PCB 514, plenums, or any other components around the VLC 502. In use, ASIC 512 generates heat and that heat is transferred from ASIC 512 to vapor chamber 516. From vapor chamber 516, heat is transferred through heat pipes 534 into fin blocks 558. Because fin blocks 558 extend outwards past the periphery of PCB 514, cooling air passes through fin blocks 558 to release heat from the ASIC 512.

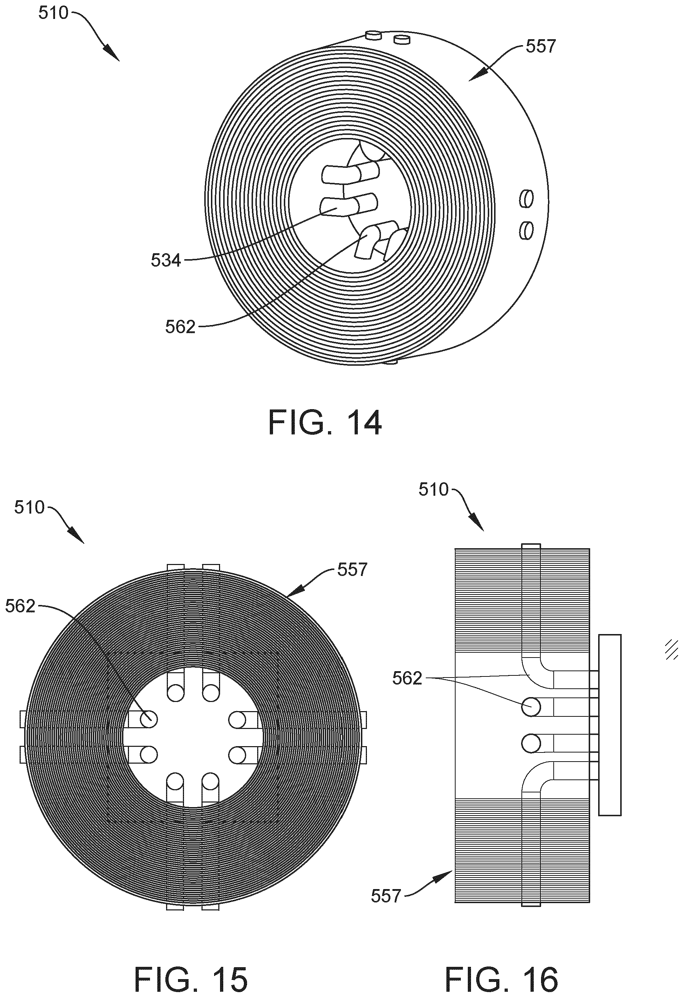

FIGS. 14-16 illustrate another implementation of the third cooling system 510 utilizing the rotary heat sink configuration, wherein Fig. 14 presents a perspective view, Fig. 15 presents a front view, and Fig. 16 presents a side view. Instead of rectangular fins, continuous circular fins 557 may extend entirely around the perimeter of the vapor chamber 516. The circular fins 557 may attach to vapor chamber 516 via heat pipes 534 that extend outward from the back surface of the ASIC 512 through apertures 560 of the circular fins 557. The heat pipes 534 may be bent or otherwise contoured to prevent circular fins 557 from contacting components of VLC 502 and improperly transferring heat back to PCB 514. It is also foreseeable that fins 557 may have different shapes than rectangular and circular shapes. For example, fins 557 may be polygonal with any number of sides, fins 557 may have various curvatures, and the like.

The third cooling system 510 on the downstream end of VLC 502 allows for a higher volumetric heat transfer efficiency as opposed to having a single heat sink positioned on the back side of the ASIC without additional heat pipes and fins. A rotary heat pipe configuration minimizes the surface area of each condenser that is exposed to preheated air. Additionally, the rotary configuration is advantageous as the incoming air can first be used to cool the optic ports 564 on the front side of PCB 514, and then be reused to cool ASIC 512 on the back side of PCB 514.

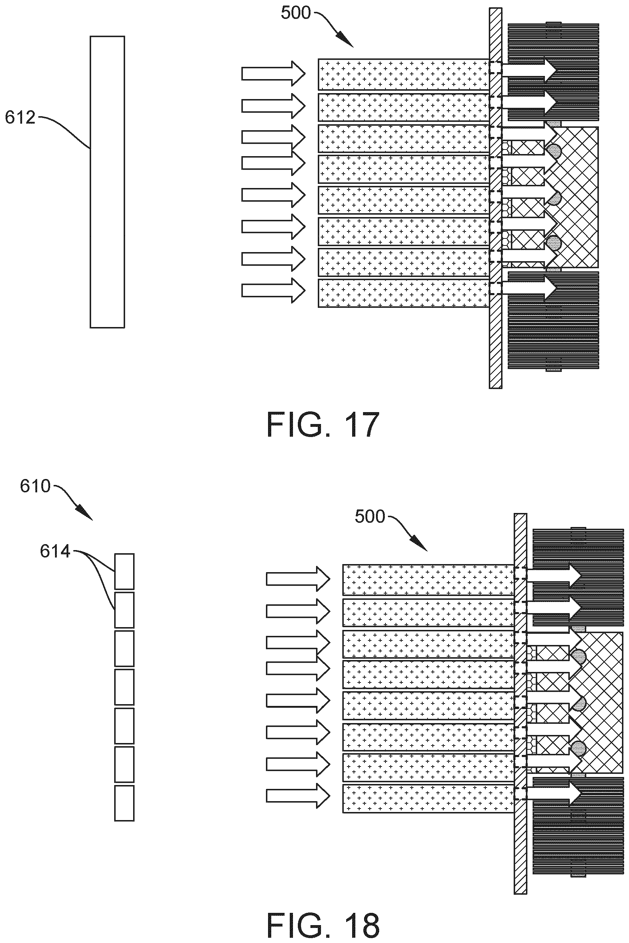

FIGS. 17-18 illustrates fan system 610 that can be utilized with any of the cooling systems described herein. Such a fan system 610 may be positioned in front of a VLC, behind the VLC, or in any combination adjacent to the VLC. For illustration purposes, fan system 610 is shown with cooling system 510. For fan system 610, an ASIC may be mounted on either the front side or back side of the PCB, and any of the various heat sink arrangements described herein may be attached to the ASIC. Further, a jet impingement manifold may be attached to a chassis of the VLC to direct airflow toward critical components on the PCB, such as the ASIC.

Traditional fans for data centers are often large diameter axial fans 612 that span the entire height of the chassis. These fans consume large amounts of power and provide a uniform distribution of air to the underlying chassis. Fan system 610 includes a plurality of small diameter axial fans 614 that are individually stacked on top of each other or otherwise positioned adjacent to each other. Such a fan arrangement allows for certain fans to turn at a higher velocity and direct air toward critical components of a VLC that generate more heat, such as an ASIC and optics ports. The fans turning at a lower rpm consume less power and are aimed at the components of the VLC that generate less heat, such as the lateral edges of the PCB. Various baffles may be positioned between the individual fans and the VLC chassis to direct the airflow to the VLC. Additionally, the individual fans 614 may be implemented with the jet impingement manifold described herein to further direct air to critical components of the PCB. Because the individual fans 614 consume different amounts of power, the entire fan system 610 as a whole consumes less power than a single fan 612, thus increasing energy efficiency. Fan system 610 may further include various temperature sensors placed through the associated data center to monitor the temperature over a period of time. If the temperature sensors indicate that the temperature of certain VLC components has risen to a critical level, a controller can activate individual fans to direct air to that component of the VLC.

Although the implementations disclosed herein have been described with reference to particular features, it is to be understood that these features are merely illustrative of the principles and applications of the present implementations. It is therefore to be understood that numerous modifications, including changes in the sizes of the various features described herein, may be made to the illustrative implementations and that other arrangements may be devised without departing from the spirit and scope of the present implementations. In this regard, the present implementations encompass numerous additional features in addition to those specific features set forth in the paragraphs above.

## Claims

1. A system for cooling a vertical line card comprising:
a printed circuit board;
an application specific integrated circuit (ASIC) having a front surface, a back surface, and an edge surface connecting the front and back surfaces, the ASIC mountable on the printed circuit board; and
a vapor chamber mountable on the ASIC, the vapor chamber including a first portion mountable on the front surface of the ASIC and extending away from the front surface and a second portion in fluid communication with the first portion extending away from the first portion at an angle relative to the first portion.

2. The system of claim 1, wherein the first portion of the vapor chamber is configured to be soldered to the ASIC.

3. The system of claim 1 or 2, wherein the second portion of the vapor chamber extends substantially orthogonal relative to the first portion.

4. The system of claim 3, further comprising a third portion of the vapor chamber extending substantially orthogonal relative to the first portion and parallel relative to the second portion, the vertical line card positionable between the second and third portions.

5. The system of claim 4, further comprising a first heat pipe configured to connect the first portion to the second portion, and a second heat pipe configured to connect the first portion to the third portion.

6. The system of any one of the preceding claims, wherein the first portion of the vapor chamber includes an evaporator; and/or
wherein the second portion of the vapor chamber includes a condenser.

7. The system of any one of the preceding claims, further comprising an airflow manifold mountable to a front surface of the first portion of the vapor chamber.

8. The system of claim 7, wherein the airflow manifold includes a plurality of apertures, each aperture of the plurality of apertures spaced apart from an adjacent aperture.

9. The system of claim 8, wherein when the airflow manifold is in a mounted configuration, each aperture aligns with a component of the printed circuit board; and/or
wherein an aperture includes a tapered opening.

10. The system of any one of the preceding claims, further comprising a plurality of fans, each fan of the plurality of fans stacked on top of an adjacent fan; and
wherein optionally each fan includes an individual power controller.

11. A system for cooling a vertical line card comprising:
a printed circuit board;
an application specific integrated circuit (ASIC) mountable on a back side of the printed circuit board such that the ASIC and the printed circuit board both extend along substantially vertical planes;
a heat sink mountable on the ASIC;
a heat pipe extending from the heat sink; and
a fin mountable on the heat pipe.

12. The system of claim 11, wherein the ASIC is mountable to a back surface of the printed circuit board; or
wherein the heat sink is a vapor chamber.

13. The system of claim 11 or 12, wherein the heat pipe includes a plurality of heat pipes, each heat pipe extending radially outward from the heat sink.

14. The system of claim 13, wherein the plurality of heat pipes extend radially outward from each of four lateral surfaces of the heat sink; and
wherein optionally the fin includes a plurality of fins forming a fin block, each fin block mountable on a set of three heat pipes.

15. The system of claim 13 or 14, wherein the fin is circular; and
wherein optionally the fin extends entirely around the perimeter of the heat sink.
